# EUROPÄISCHE PATENTSCHRIFT

(11) **EP 0 638 786 B1**
(45) Veröffentlichungstag und Bekanntmachung des Hinweises auf die Patenterteilung: **13.11.1996**
(21) Anmeldenummer: 94108757.9
(22) Anmeldetag: 08.06.1994
(51) Int. Cl.: G01F 15/06, G01R 21/133

(54) **Ausgangsschaltung für einen Zähler, insbesondere einen Wärmezähler**
Output circuit for a counter, in particular for a heat meter
Circuit de sortie pour un compteur, en particulier pour un compteur de chaleur

(30) Priorität: 13.08.1993 CH 2409/93
(43) Veröffentlichungstag der Anmeldung: 15.02.1995
(73) Patentinhaber: Landis & Gyr Business Support AG, 6301 Zug (CH)
(72) Erfinder: Reichert, Peter, Dipl.-Ing., D-63526 Erlensee (DE)
(74) Vertreter: EGLI-EUROPEAN PATENT ATTORNEYS

(56) Entgegenhaltungen:
- GB-A- 2 101 781
- PATENT ABSTRACTS OF JAPAN vol. 13, no. 513 (E-847) 16. November 1989 & JP-A-01 208 094 (CANON INC)
- PATENT ABSTRACTS OF JAPAN vol. 6, no. 128 (E-118) 14. Juli 1982 & JP-A-57 054 424 (TOSHIBA CORP)

## Beschreibung

Die Erfindung betrifft eine Ausgangsschaltung für einen Zähler, insbesondere einen Wärmezähler zur elektrischen Fernabfrage des Wärmezählerstandes gemäss dem Oberbegriff des Anspruches 1.

Wärmezähler werden meist mit einer Ausgangsschaltung zur elektrischen Fernabfrage des Wärmezählerstandes ausgerüstet, damit die Ermittlung des Wärmeverbrauchs ohne Störung und Beeinträchtigung für den Wärmebezüger jederzeit erfolgen kann. Derartige Ausgangsschaltungen sollen kostengünstig, stromsparend und funktionssicher sein.

Da Wärmezähler oft mit einer eingebauten Batterie von beschränkter Kapazität arbeiten, ist es unerwünscht, dass der Vorgang der Fernabfrage des Wärmezählerstandes die Batterie zusätzlich belastet und so deren Lebensdauer verkürzt. Es werden deshalb Ausgangsschaltungen verwendet, bei denen das anzuschliessende Gerät zur Fernabfrage die notwendige Energie für die Fernabfrage des Wärmezählerstandes aufbringt.

Weil falsch angeschlossene Fernabfrageleitungen zu Funktionsstörungen oder zu Defekten führen können, wird der Anschluss für das Gerät zur Fernabfrage polvertauschbar ausgeführt. Somit muss beim Anschluss der Fernabfrageleitungen nicht auf deren Polarität geachtet werden und es treten infolgedessen auch keine Verdrahtungsfehler auf.

Bei dem im Handel erhältlichen Ausgangsschaltungs-Modul des Typs WSC der Firma Landis & Gyr wird eine Ausgangsschaltung dieser Art zur Fernabfrage des Wärmezählerstandes eingesetzt.

Die zur Fernabfrage notwendige Spannungsversorgung wird von einem an Ausgangsanschlüssen anzuschliessenden Gerät zur Fernabfrage aufgebracht. Das Modul weist eine mit den Ausgangskontakten eines Brückengleichrichters verbundene Oszillatorschaltung auf, die über die Eingangskontakte des Brückengleichrichters mit den Modul-Ausgangsanschlüssen verbunden ist. Die Oszillatorschaltung wird somit vom Gerät zur Fernabfrage mit Spannung versorgt. Die Oszillatorschaltung ist durch ein an einem Modul-Eingangsanschluss anliegendes Signal vom Wärmezähler in ihrem Schalt- bzw. Schwingungszustand umschaltbar. Die Oszillatorschaltung enthält einen mit einer Induktivität und einer Kapazität beschalteten Oszillator, der entweder frei schwingt oder bei Ansteuerung durch einen Feldeffekttransistor in der Schwingungsamplitude bedämpft ist.

Bei dieser Schaltung fliesst ein vom Schalt- bzw. Schwingungszustand der Oszillatorschaltung bestimmter Strom vom Gerät zur Fernabfrage über den Brückengleichrichter durch die Schaltung. Wegen der digitalen Ansteuerung der Oszillatorschaltung können zwei Signalzustände als Folge unterschiedlich grosser Ströme vom Gerät zur Fernabfrage detektiert werden. Wegen des Brückengleichrichters ist die Schaltung polvertauschbar, d.h. es spielt keine Rolle, wie das Gerät zur Fernabfrage an den Ausgangsanschlüssen angeschlossen wird. Die Schaltung hat allerdings den Nachteil, dass sie schaltungstechnisch ziemlich aufwendig ist, keine besonders gute EMV-Festigkeit aufweist und zudem einen relativ hohen Stromverbrauch für die Ansteuerung der Oszillatorschaltung aufweist.

Eine weitere Lösung ist aus der GB-A-2 101 781 bekannt. Die Schrift zeigt einen zur Fernabfrage geeigneten Zähler zur Erfassung des Gas- Wasser- oder Energieverbrauchs mit einer Schaltung zur Erzeugung von elektrischen Zählpulsen in Abhängigkeit des Verbrauchs. Zur Fernabfrage wird eine elektrische Spannung an Ausgangsanschlüssen angelegt. Die elektrischen Zählpulse werden von einem schaltbaren Bauelement erzeugt, das aus einem Widerstand und einem parallel zu diesem Widerstand angeschlossenen Relaiskontakt im Stromkreis der Fernabfragespannung besteht. Die Schaltung weist keinen Brückengleichrichter auf und kann somit auch nicht verhindern, dass die elektrische Abfragespannung in falscher Polarität am schaltbaren Bauelement angelegt wird. Allerdings erfordert das offenbarte schaltbare Bauelement (Relais) auch keine solche Massnahme. Wegen des verwendeten Relaiskontaktes weist die Schaltung einen relativ hohen Stromverbrauch zur Erzeugung der Zählpulse auf.

Schaltungen mit Brückengleichrichtern zum Verhindern der Vertauschung der Polarität werden auch in anderen Bereichen eingesetzt. So beschreibt die JP-A-01 208 094 eine Interface-Schaltung zu einer Telefon-Hauptzentrale bei der eine Aussen-Zentrale über eine Leitung und einen Brückengleichrichter an der Hauptzentrale angeschlossen ist. Der Brückengleichrichter verhindert, dass die Gleichspannung auf der Leitung in falscher Polarität auf die Hauptzentrale gelangt. Am Ausgang des Brückengleichrichters ist ein schaltbares Bauelement in Form einer Darlington-Transistorstufe angeschlossen. Die Darlington-Transistorstufe wird von einer Steuereinheit gesteuert und dient dazu, im Falle eines eingehenden oder eines ausgehenden Telefongesprächs einen Gleichstromkreis zu bilden. Die Schaltung weist aber keinen direkt am Ausgang des Brückengleichrichters angeschlossenen Widerstand auf und die Darlington-Transistorstufe dient auch nicht dazu, den Stromfluss im Gleichstromkreis pulsartig zu modulieren und Zählpulse zu erzeugen.

Die Aufgabe besteht darin, eine Ausgangsschaltung für einen Zähler, insbesondere einen Wärmezähler, zur elektrischen Fernabfrage des Zählerstandes anzugeben, die schaltungstechnisch einfach ist, deren Komponenten gegen Polvertauschung der Abfragespannung geschützt sind, die einen niedrigen Stromverbrauch aufweist und zudem verbesserte EMV-Eigenschaften besitzt.

Diese Aufgabe wird durch die im Kennzeichen des Patentanspruches 1 gegebene Lehre gelöst.

Der Vorteil der Erfindung besteht darin, dass einfache elektronische Standardkomponenten verwendet werden können und dass die Schaltung einen besonders niedrigen Stromverbrauch besitzt, was durch die Verwendung eines Darlingtonschalters erreicht wird, der nur einen sehr kleinen, von der Batterie des Zählers zu liefernden Basisstrom benötigt.

Ein weiterer Vorteil liegt darin, dass die Schaltung besonders gute EMV-Eigenschaften(Elektro Magnetische Verträglichkeit) besitzt. Dadurch wird die Störanfälligkeit von Fernabfragen für Zähler infolge äusserer elektromagnetischer Einflüsse vermindert. Erreicht wird dies durch die Verwendung zweier Widerstände und eines Kondensators am Eingang des Brückengleichrichters.

Ein Ausführungsbeispiel der Erfindung wird im folgenden anhand einer einzigen Zeichnung näher erläutert.

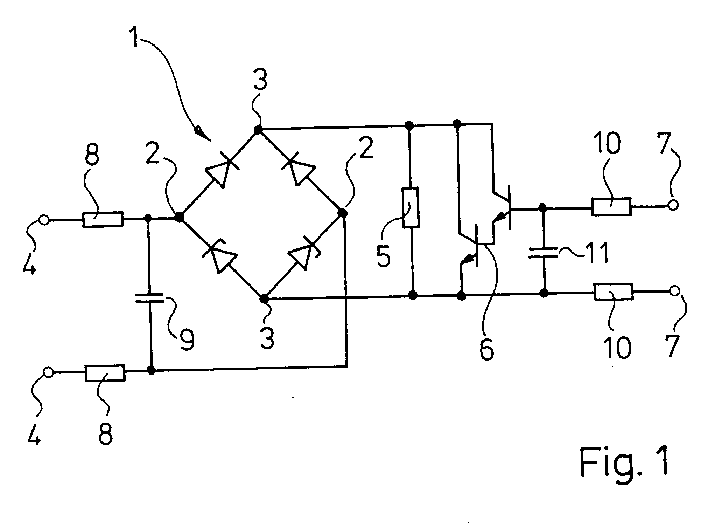

Figur 1 zeigt eine Ausgangsschaltung für einen Wärmezähler zur elektrischen Fernabfrage des Wärmezählerstandes.

Die Ausgangsschaltung weist einen Brückengleichrichter 1 mit Eingangskontakten 2 und Ausgangskontakten 3 auf. Die Eingangskontakte 2 des Brückengleichrichters 1 sind mit Ausgangsanschlüssen 4 der Ausgangsschaltung verbunden. Ein Bauelement, das einen Widerstand 5 und eine parallel zum Widerstand 5 angeschlossene Darlington-Schaltung 6 enthält, ist mit den Ausgangskontakten 3 des Brückengleichrichters 1 verbunden. Die Darlington-Schaltung 6 wird von einem an Eingangsanschlüssen 7 anliegenden Signal vom Wärmezähler gesteuert.

Die Eingangskontakte 2 des Brückengleichrichters 1 sind über gleiche Begrenzungswiderstände 8 mit den Ausgangsanschlüssen 4 verbunden. Die Eingangskontakte 2 des Brückengleichrichters 1 sind zudem über einen Filterkondensator 9 miteinander verbunden. Die Begrenzungswiderstände 8 und der Filterkondensator 9 dienen der Verbesserung der EMV-Eigenschaften der Ausgangsschaltung.

Die Darlington-Schaltung 6 ist eine NPN-Transistorschaltung, deren Basis- und Emitteranschlüsse über Schutzwiderstände 10 mit den Eingangsanschlüssen 7 verbunden sind. Der Basis- und der Emitteranschluss der Darlington-Schaltung 6 sind über einen Eingangsfilterkondensator 11 miteinander verbunden. Die Schutzwiderstände 10 und der Eingangsfilterkondensator 11 dienen ebenfalls der Verbesserung der EMV-Eigenschaften der Ausgangsschaltung.

Sind entsprechende EMV-Schutzmassnahmen bereits im Wärmezähler realisiert, so können der Eingangsfilterkondensator 11 und der emitterseitige Schutzwiderstand 10 entfallen.

Die vom Wärmezähler ans Gerät zur Fernabfrage zu übertragenden Daten liegen als digitales Signal an den Eingangsanschlüssen 7 und steuern die Basis der Darlingtonschaltung 6. Die Darlingtonschaltung 6 sperrt in dem einen Zustand und in dem anderen schliesst sie den Widerstand 5 kurz. Daraus ergibt sich, dass der Gesamtwiderstand zwischen den Ausgangsanschlüssen 4 in dem einen Zustand die Summe der Begrenzungswiderstände 8 und des Widerstandes 5 ist, in dem anderen Zustand lediglich die Summe der Begrenzungswiderstände 8. Da an den Ausgangsanschlüssen 4 (über nicht dargestellte Verbindungsleitungen) vom Gerät zur Fernabfrage eine Spannungsversorgung angelegt wird, fliesst je nach Schaltzustand der Darlingtonschaltung 6 ein unterschiedlich grosser Strom durch die Schaltung. Dieser Unterschied in der Stromstärke repräsentiert somit die im digitalen Signal enthaltenen Informationen und wird vom Gerät zur Fernabfrage detektiert und ausgewertet. Wegen des Brückengleichrichters 1 ist die Schaltung polvertauschbar, d.h. es spielt keine Rolle, in welcher Polarität die Spannungsversorgung an den Ausgangsanschlüssen 4 angelegt wird.

Zur Gewährleistung der beschriebenen Funktion wäre nur ein Begrenzungswiderstand 8 in einem der beiden Anschlusszweige zu den Ausgangsanschlüssen 4 notwendig. Dann aber könnten über denjenigen Anschlusszweig, der nicht mit einem Begrenzungswiderstand 8 versehen ist, elektrische Störsignale ungedämpft in das Innere der Ausgangsschaltung gelangen. Um die elektromagnetische Verträglichkeit (EMV) der Ausgangsschaltung gegen Störsignale zu erhöhen, sind deshalb Begrenzungswiderstände 8 in beide Anschlusszweige gelegt. Hochfrequente Störsignale werden vom Filterkondensator 9 kurzgeschlossen, bevor sie zum Brückengleichrichter 1 gelangen. Die Schutzwiderstände 10 und der Eingangsfilterkondensator 11 bei den Eingangsanschlüssen erfüllen entsprechende Funktionen.

Die Energie, die zum Uebertragen der Daten notwendig ist, wird im wesentlichen vom Empfänger, nämlich vom anzuschliessenden Gerät zur Fernabfrage aufgebracht. Man kann deshalb von einer Fernspeisung der Ausgangsschaltung sprechen. Der Datensender, nämlich der Wärmezähler, muss wegen der Darlington-Schaltung 6 nur einen sehr geringen Strom aufbringen, um den Schaltzustand derselben zu ändern. Weil der Strombedarf der Schaltung so gering ist, eignet sich die Ausgangsschaltung sehr gut für den Betrieb mit batterieversorgten Wärmezählern.

Im Vergleich zu der bekannten Schaltung dieser Art sind die Bauteilekosten sehr gering und der Zuwachs an Sicherheit gegen elektromagnetische Störeinflüsse (EMV) beträchtlich.

## Patentansprüche

1. Ausgangsschaltung für einen Zähler, insbesondere einen Wärmezähler, zur elektrischen Fernabfrage des Zählerstandes, wobei eine zur Fernabfrage des Zählers notwendige Spannungversorgung von einem an Ausgangsanschlüssen (4) anzuschliessenden Gerät zur Fernabfrage aufgebracht wird, mit einem mit den Ausgangsanschlüssen (4) verbundenen schaltbaren Bauelement das aus einem Widerstand (5) und einem parallel zum Widerstand (5) angeschlossenen Schaltelement besteht, wobei der Schaltzustand des Schaltelements vom Zähler gesteuert wird, **dadurch gekennzeichnet, dass**
- das schaltbare Bauelement über einen Brückengleichrichter (1) mit den Ausgangsanschlüssen (4) verbunden ist, wobei das schaltbare Bauelement mit Ausgangskontakten (3) des Brückengleichrichters (1) und Eingangskontakte (2) des Brückengleichrichters (1) mit den Ausgangsanschlüssen (4) verbunden sind,
- das Schaltelement eine Darlington-Schaltung (6) ist die von einem an Eingangsanschlüssen (7) anliegenden Signal vom Wärmezähler gesteuert wird,
- die Eingangskontakte (2) des Brückengleichrichters (1) mit gleichen Begrenzungswiderständen (8) mit den Ausgangsanschlüssen (4) verbunden sind und
- die Eingangskontakte (2) des Brückengleichrichters (1) mit einem Filterkondensator (9) verbunden sind.

2. Ausgangsschaltung nach Anspruch 1, **dadurch gekennzeichnet, dass** die Eingangsanschlüsse (7) über ein Tiefpassfilter mit der Darlington-Schaltung (6) verbunden sind.

## Claims

1. Output circuit for a meter, in particular a heat meter, for electrical remote interrogation of the meter reading, a voltage supply which is necessary for remote interrogation of the meter being applied, for remote interrogation, from a unit which can be connected to output connections (4), having a switchable component which is connected to the output connections (4) and comprises a resistor (5) and a switching element which is connected in parallel with the resistor (5), the switching state of the switching element being controlled by the meter,
characterized in that
- the switchable component is connected via a bridge rectifier (1) to the output connections (4), the switchable component being connected to output contacts (3) of the bridge rectifier (1), and input contacts (2) of the bridge rectifier (1) being connected to the output connections (4),
- the switching element is a Darlington circuit (6) which is controlled from the heat meter by a signal which is applied to input connections (7),
- the input contacts (2) of the bridge rectifier (1) are connected by means of identical limiting resistors (8) to the output connections (4), and
- the input contacts (2) of the bridge rectifier (1) are connected to a filter capacitor (9).

2. Output circuit according to Claim 1, characterized in that the input connections (7) are connected to the Darlington circuit (6) via a low-pass filter.

## Revendications

1. Circuit de sortie pour un compteur, en particulier un compteur de chaleur, pour l'interrogation électrique à distance de l'indication du compteur, dans lequel une alimentation de tension requise pour l'interrogation du compteur à distance est appliquée à partir d'un appareil pour l'interrogation à distance qui doit venir se raccorder à des raccords de sortie (4), comprenant un élément de montage commutable relié aux raccords de sortie (4), qui est constitué par une résistance (5) et par un élément de commutation monté en parallèle à la résistance (5), l'état de commutation de l'élément de commutation étant commandé par le compteur,
caractérisé en ce que
- l'élément de montage commutable est relié aux raccords de sortie (4) via un redresseur à pont (1), l'élément de montage commutable étant relié à des contacts de sortie (3) du redresseur à pont (1) et des contacts d'entrée (2) du redresseur à pont (1) étant reliés aux raccords de sortie (4),
- l'élément de commutation est un circuit Darlington (6) qui est commandé par un signal du compteur de chaleur adjacent aux raccords d'entrée (7),
- les contacts d'entrée (2) du redresseur à pont (1) munis de résistances de limitation analogues (8) sont reliés aux raccords de sortie (4), et
- les contacts d'entrée (2) du redresseur à pont (1) sont reliés à un condensateur filtrant (9).

2. Circuit de sortie selon la revendication 1, caractérisé en ce que les raccords d'entrée (7) sont reliés au circuit Darlington (6) via un filtre passe-bas.
